# EUROPEAN PATENT APPLICATION

(11) **EP 4 693 258 A1**
(43) Date of publication of application: **11.02.2026**
(21) Application number: 24787831.7
(22) Date of filing: 01.03.2024
(51) Int. Cl.: G09F 9/30

(54) **FOLDABLE DEVICE**

(30) Priority: 13.04.2023 CN 202310422648
(71) Applicant: Huawei Technologies Co., Ltd., Shenzhen, Guangdong 518129 (CN)
(72) Inventor: JIANG, Tiezhu, Shenzhen, Guangdong 518129 (CN); XU, Haibo, Shenzhen, Guangdong 518129 (CN); YU, Wenbin, Shenzhen, Guangdong 518129 (CN); XING, Chong, Shenzhen, Guangdong 518129 (CN)
(74) Representative: Epping - Hermann - Fischer
(86) International application number: PCT/CN2024/079685
(87) International publication number: WO 2024/212725

(57) **Abstract**

A foldable device is provided, and relates to the technical field of electronic devices, to resolve problems of a large thickness dimension and a low screen-to-body ratio of the foldable device. The foldable device may include a flexible display (01), a first housing (10), a second housing (20), and a hinge (30). The first housing (10) and the second housing (20) are symmetrically disposed with respect to the hinge (30). The flexible display (01) includes a backplane (011). The backplane (011) has a first board surface (0111) and a second board surface (0112) that face away from each other. The back of a display panel (012) is disposed on the first board surface (0111). The first housing (10) includes a first body (11) and a first side frame (12) that are fastened. The first body (11) has a first mounting surface (111). The second board surface (0112) of the backplane (011) is disposed on the first mounting surface (111). The first side frame (12) has a first limiting surface (121). The backplane (011) is limited between the first limiting surface (121) and the first mounting surface (111). The first side frame (12) effectively limits the backplane (011) of the flexible display (01), to facilitate reduction of the thickness dimension of the foldable device; and further reduce blocking of the flexible display (01) by the first side frame (12) and the second side frame (22), facilitating an increase in the screen-to-body ratio of the foldable device.

## Description

### CROSS-REFERENCE TO RELATED APPLICATIONS

This application claims priority to Chinese Patent Application No. 202310422648.7, filed with the China National Intellectual Property Administration on April 13, 2023 and entitled "FOLDABLE DEVICE", which is incorporated herein by reference in its entirety.

### TECHNICAL FIELD

This application relates to the technical field of electronic devices, and in particular, to a foldable device.

### BACKGROUND

A foldable device usually includes a flexible display and two separate housings. The two housings may be connected by a hinge. A middle region of the flexible display may be fastened to some components in the hinge, and two ends of the flexible display may be respectively disposed on the two housings. In a process of the foldable device being unfolded or folded, the two housings may be unfolded or folded relative to each other via the hinge, to implement a foldable function. However, in existing foldable devices, to ensure use safety and posture control of the flexible display, a side frame is usually arranged around an edge of the flexible display. The side frame has a large width and protrudes from a display surface of the flexible display. The protruding side frame increases a thickness dimension of the foldable device, and blocks a part of the edge of the flexible display. When a hand touches or swipes near the edge of the flexible display, interference from the side frame may occur, causing an undesirable problem like hand scratching. Therefore, how to reduce a protrusion height of the side frame and a blocked area of the flexible display has become an urgent technical problem to be resolved.

### SUMMARY

This application provides a foldable device that facilitates reduction of a thickness dimension of the foldable device and further reduces an area of a flexible display that is blocked by a side frame. A foldable device may include a flexible display, a first housing, a second housing, and a hinge. The first housing and the second housing are respectively located on two sides of the hinge and are connected to the hinge. The first housing may be folded relative to the second housing via the hinge, to implement a folding function of the foldable device. A region of the flexible display is disposed on the first housing, another region is disposed on the second housing, and a middle region is disposed on the hinge. The flexible display has specific flexibility. Therefore, when the first housing and the second housing are folded via the hinge, the flexible display may be subject to bending deformation. The flexible display may include a backplane and a display panel. The backplane has a first board surface and a second board surface that face away from each other, and the back of the display panel is disposed on the first board surface. The first housing includes a first body and a first side frame that are fastened. The first body has a first mounting surface, and the second board surface of the backplane is disposed on the first mounting surface. The first side frame has a first limiting surface. The first limiting surface is disposed facing the first mounting surface. The first limiting surface is configured to press against the first board surface, and a part of an edge of the backplane is limited between the first limiting surface and the first mounting surface. The second housing includes a second body. The second body has a second mounting surface, and the second board surface of the backplane is disposed on the second mounting surface. In the example provided in this application, the first side frame of the first housing effectively limits the backplane of the flexible display, so that the flexible display can be prevented from being detached from the first housing. Therefore, a height dimension of the first side frame protruding from the display surface of the display panel can be effectively reduced. This facilitates reduction of a thickness dimension of the foldable device, and further reduces blocking of the flexible display by the first side frame, facilitating an increase in a screen-to-body ratio of the foldable device.

In an example, the first side frame may have a first side and a second side. The first limiting surface may be on the first side and the second side, so that the first side and the second side can be prevented from blocking the display panel of the flexible display, facilitating the increase in the screen-to-body ratio of the foldable device.

In an example, the first side and the second side may be disposed opposite to each other. That is, the first side and the second side may be two opposite sides of the first side frame. The first side and the second side that are disposed opposite to each other can allow for a relatively good limiting effect for the backplane of the flexible display.

In an example, the second housing may further include a second side frame. The second side frame is fastened to the second body. The second side frame has a second limiting surface. The second limiting surface is disposed facing the second mounting surface, and a part of an edge of the backplane is limited between the second limiting surface and the second mounting surface. The second side frame of the second housing effectively limits the backplane, so that the flexible display can be prevented from being detached from the second housing. Therefore, a height dimension of the second side frame protruding from the display surface of the display panel can be effectively reduced, and blocking of the flexible display by the second side frame is further reduced, facilitating the increase in the screen-to-body ratio of the foldable device.

In an example, the second side frame may have a third side and a fourth side. The second limiting surface may be on the third side and the fourth side, so that the third side and the fourth side can be prevented from blocking the display panel of the flexible display, facilitating the increase in the screen-to-body ratio of the foldable device.

In an example, the third side and the fourth side may be disposed opposite to each other. That is, the third side and the fourth side may be two opposite sides of the second side frame. The third side and the fourth side that are disposed opposite to each other can allow for a relatively good limiting effect for the backplane of the flexible display.

In an example, the first limiting surface may lap the first board surface. For the first housing and the flexible display, the lap between the first limiting surface and the first board surface can be used to effectively prevent the flexible display from being detached from the first housing. The second limiting surface may lap the first board surface. For the second housing and the flexible display, the lap between the second limiting surface and the second board surface can be used to effectively prevent the flexible display from being detached from the second housing.

In an example, the foldable device may further include a first sealing strip and a second sealing strip. The first sealing strip may be located between the first limiting surface and the first board surface, and the first sealing strip is fastened to the first side frame or the backplane, to improve sealing performance between the first limiting surface and the first board surface. The second sealing strip may be located between the second limiting surface and the first board surface, and the second sealing strip is fastened to the second side frame or the backplane, to improve sealing performance between the second limiting surface and the first board surface.

In an example, the foldable device further includes a protective film layer. The protective film layer is disposed on a display surface of the display panel, and at least a part of an edge of the protective film layer extends beyond an edge of the display panel. In other words, an area of the protective film layer may be greater than an area of the display panel, so that a gap between the flexible display and the first housing and a gap between the flexible display and the second housing can be reduced.

In an example, in a direction away from the first mounting surface, a surface of the first side frame protrudes from a surface of the protective film layer, or the surface of the first side frame is flush with the surface of the protective film layer. In this way, the first side frame can effectively protect a side of the flexible display. In a direction away from the second mounting surface, a surface of the second side frame protrudes from the surface of the protective film layer, or the surface of the second side frame is flush with the surface of the protective film layer. In this way, the second side frame can effectively protect a side of the flexible display.

In an example, there may be a first gap between a side of the backplane and the first side frame, there is a second gap between the display panel and the first side frame, there is a third gap between a side of the protective film layer and the first side frame, and the second gap may be greater than the first gap or the third gap. This can effectively prevent contact between the protective film layer and the first side frame, thereby ensuring safety of the protective film layer. There is a fourth gap between a side of the backplane and the second side frame, there is a fifth gap between the display panel and the second side frame, there is a sixth gap between a side of the protective film layer and the second side frame, and the fifth gap may be greater than the third gap or the sixth gap. This can effectively prevent contact between the protective film layer and the second side frame, thereby ensuring safety of the protective film layer.

In an example, the hinge has a support plate, and the second board surface of the backplane is fastened to the support plate. The support plate can effectively support the flexible display, to ensure flatness of the flexible display. In a folding or unfolding process of the mobile phone, the support plate may exert a force on the flexible display, and effectively control a bending posture of the flexible display, to prevent the flexible display from an undesirable problem like a crease or fracture.

In an example, the foldable device further includes a first flexible adhesive layer and a second flexible adhesive layer. The first flexible adhesive layer is located between the first body and the backplane and is flexibly bonded to the second board surface and the first mounting surface. The first flexible adhesive layer can limit the backplane onto the first mounting surface of the first housing via adhesiveness of the first flexible adhesive layer, to prevent an undesirable case of warping or bulge between the backplane and the first mounting surface. In addition, the relatively good flexibility of the first flexible adhesive layer can allow for relative displacement between the backplane and the first housing. This can effectively prevent the first housing from significantly pulling or pressing the flexible display. The second flexible adhesive layer is located between the second body and the backplane and is flexibly bonded to the second board surface and the second mounting surface. The second flexible adhesive layer can limit the backplane onto the second mounting surface of the second housing via adhesiveness of the second flexible adhesive layer, to prevent an undesirable case of warping or bulge between the backplane and the second mounting surface. In addition, the relatively good flexibility of the second flexible adhesive layer can allow for relative displacement between the backplane and the second housing. This can effectively prevent the second housing from significantly pulling or pressing the flexible display.

In an example, the first body may have a first mounting groove, and one end of the first side frame is fastened in the first mounting groove. The second body has a second mounting groove, and one end of the second side frame is fastened in the second mounting groove.

In an example, the hinge includes a hinge side frame, the hinge side frame is located between the first side frame and the second side frame, and a side of the hinge side frame adjacent to the flexible display is lower than or flush with the flexible display. The hinge side frame can effectively connect the first side frame and the second side frame. In addition, the hinge side frame can provide good protection for the side of the flexible display, to prevent the flexible display from being bumped by a foreign matter.

In the conventional technology, the hinge side frame needs to cover the flexible display, and the hinge side frame needs to have specific stiffness to protect the flexible display. Therefore, a material with good stiffness needs to be selected for the hinge side frame. During specific configuration of this application, the hinge side frame does not need to cover the flexible display as in the conventional technology, but can be designed to be lower than the flexible display or flush with the flexible display. Therefore, a soft material like rubber or plastic may be used, thereby improving flexibility in material selection.

### BRIEF DESCRIPTION OF DRAWINGS

FIG. 1 is a diagram of a structure of a foldable device in an unfolded state according to an embodiment of this application;
FIG. 2 is a diagram of a structure of a foldable device in a folded state according to an embodiment of this application;
FIG. 3 is an A-A sectional view of FIG. 1;
FIG. 4 is a schematic exploded view of a structure of a foldable device according to an embodiment of this application;
FIG. 5 is a schematic plan view of a structure of a foldable device according to an embodiment of this application;
FIG. 6 is a B-B sectional view of FIG. 5;
FIG. 7 is a sectional view of a structure of another foldable device according to an embodiment of this application; and
FIG. 8 is a C-C sectional view of FIG. 5.

### DESCRIPTION OF EMBODIMENTS

To make the objectives, technical solutions, and advantages of this application clearer, the following further describes this application in detail with reference to the accompanying drawings. A foldable device is specifically an electronic device that can change its form through folding, rotation, or the like. Under different use requirement conditions, a user may fold or unfold the foldable device to meet different requirements of the user.

When carrying the foldable device with themselves, the user may fold the foldable device to reduce the size of the foldable device, thereby improving portability of the foldable device. When using the foldable device, the user may unfold the foldable device to provide a larger display region and operation region, thereby improving use convenience. During actual application, there may be a plurality of types of foldable devices. For example, the foldable device may be specifically a mobile phone, a tablet computer, a notebook computer, an e-book, or the like.

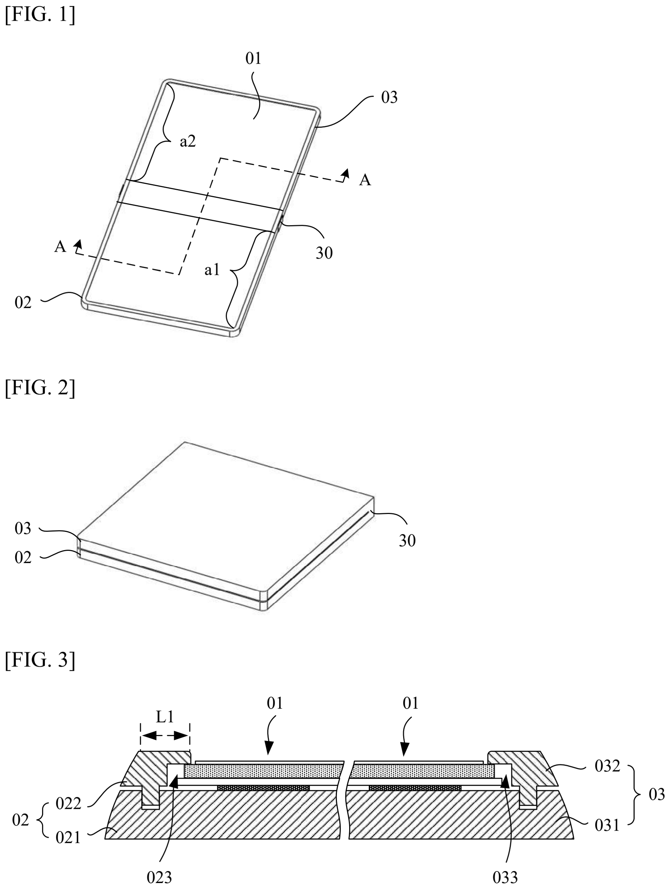

As shown in FIG. 1, a mobile phone is used as an example. The mobile phone may include a first housing 02 and a second housing 03 that are connected by a hinge 30. Under an action of the hinge 30, relative rotation, movement, or the like can be generated between the first housing 02 and the second housing 03. A flexible display 01 (for example, an OLED screen) may be disposed on a surface of the first housing 02 and of the second housing 03. As shown in FIG. 1, when the mobile phone is unfolded, the flexible display 01 may provide a larger display area and operation region, to improve use performance. As shown in FIG. 2, after the mobile phone is folded, the flexible display (not shown in the figure) may be on an inner side of the mobile phone, so that an area of the mobile phone can be reduced, thereby improving portability of the mobile phone.

As shown in FIG. 3, in an example provided in this application, the first housing 02 may include a first body 021 and a first side frame 022. There is an accommodating groove 023 between the first body 021 and the first side frame 022, and a part of an edge (for example, a left edge in the figure) of the flexible display 01 may be located in the accommodating groove 023, to prevent the flexible display 01 from being detached from the first housing 02. Correspondingly, the second housing 03 may include a second body 031 and a second side frame 032. There is an accommodating groove 033 between the second body 031 and the second side frame 032. A part of an edge (for example, a right edge in the figure) of the flexible display 01 may be located in the accommodating groove 033, to prevent the flexible display 01 from being detached from the second housing 03.

As shown in FIG. 1 and FIG. 3, in the process of the mobile phone being folded or unfolded, relative displacement may occur between a region a1 of the flexible display 01 and the first housing 02, so that the first housing 02 can be prevented from pulling or pressing the flexible display 01. In addition, the part of the edge of the flexible display 01 can be effectively limited within the accommodating groove 023. Correspondingly, relative displacement may occur between a region of the flexible display 01 and the second housing 03, so that the second housing 03 can be prevented from pulling or pressing the flexible display 01. In addition, the part of the edge of the flexible display 01 can be effectively limited within the accommodating groove 033.

However, in the foregoing solution, the first side frame 022 has a relatively large width L1, and protrudes significantly from a display surface of the flexible display 01. The protruding side frame increases a thickness dimension of the foldable device, and blocks a part of the edge of the flexible display 01. When a hand touches or swipes near the edge of the flexible display 01, interference from the first side frame 022 and the second side frame 032 may occur, causing an undesirable problem like hand scratching.

In view of this, this application provides a foldable device that can effectively reduce a thickness dimension of the foldable device and an area of a flexible display that is blocked by a side frame. To make the objectives, technical solutions, and advantages of this application clearer, the following further describes this application in detail with reference to the accompanying drawings and specific embodiments.

Terms used in the following embodiments are merely intended to describe specific embodiments, but are not intended to limit this application. Terms "one", "a", and "this" of singular forms used in this specification and the appended claims of this application are also intended to include a form like "one or more", unless otherwise specified in the context clearly. It may be further understood that, in the following embodiments of this application, "at least one" means one, two, or more. Reference to "an embodiment" or the like described in this specification means that one or more embodiments of this application include a particular feature, structure, or characteristic described with reference to embodiments. Therefore, statements such as "in an embodiment", "in some embodiments", and "in other embodiments" that appear at different places in this specification do not necessarily refer to a same embodiment. Instead, the statements mean "one or more but not all of embodiments", unless otherwise specifically emphasized in another manner. Terms "include", "have", and their variants all mean "include but are not limited to", unless otherwise specifically emphasized in another manner.

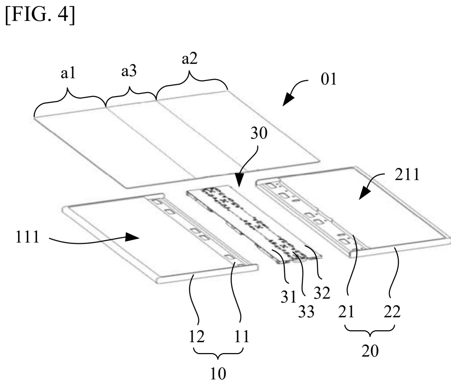

As shown in FIG. 4, in an example provided in this application, a foldable device may include a flexible display 01, a first housing 10, a second housing 20, and a hinge 30. The first housing 10 and the second housing 20 are respectively located on two sides of the hinge 30 and are connected to the hinge 30. The first housing 10 may be folded relative to the second housing 20 via the hinge 30, to implement a folding function of the foldable device. A region a1 of the flexible display 01 is disposed on the first housing 10, another region a2 is disposed on the second housing 20, and a middle region a3 is disposed on the hinge 30. The flexible display 01 has specific flexibility. Therefore, when the first housing 10 and the second housing 20 are folded via the hinge 30, the flexible display 01 may be subject to bending deformation.

Specifically, in the process of the foldable device being folded or unfolded, bending deformation occurs in the middle region a3 of the flexible display 01 under an action of the hinge 30. The region a1 of the flexible display 01 moves with the first housing 10 under an action of the first housing 10, and the region a2 moves with the second housing 20 under an action of the second housing 20. In actual application, to effectively control a bending posture of the middle region a3 of the flexible display 01, the back of the middle region a3 may be bonded to a part of the structure of the hinge 30.

For example, as shown in FIG. 4, in an example provided in this application, the hinge 30 has a support plate 31, a support plate 32, and a support plate 33. The back of the middle region a3 of the flexible display 01 may be bonded to the support plate 31, the support plate 32, and the support plate 33. When the foldable device is in an unfolded state, the support plate 31, the support plate 32, and the support plate 33 can effectively support the middle region a3 of the flexible display 01, to ensure flatness of the middle region a3. In a folding or unfolding process of the mobile phone, the support plate 31, the support plate 32, and the support plate 33 may exert a force on the flexible display 01, and effectively control a bending posture of the middle region a3, to prevent the flexible display 01 from an undesirable problem like a crease or fracture. It should be noted that, in the example in FIG. 4, the hinge 30 includes three support plates: the support plate 31, the support plate 32, and the support plate 33. The middle region a3 of the flexible display 01 may be fastened to the support plate 31 and the support plate 32, or may be fastened to the support plate 33.

It may be understood that, in actual application, the hinge 30 may further include a component like a rotating shaft, and the hinge 30 may be of a currently commonly used type. In addition, a quantity and shape of the support plates included in the hinge 30 may be flexibly selected and adjusted according to an actual situation. A specific structure of the hinge 30 and a connection manner between the hinge 30 and the flexible display 01 are not limited in this application.

In addition, in a folding or unfolding process of the mobile phone, a structure formed by the first housing 10, the hinge 30, and the second housing 20 may change in length. To prevent the first housing 10 and the second housing 20 from pulling or pressing the flexible display 01, the flexible display 01 may be connected to the first housing 10 and the second housing 20 in a non-fixed connection manner, so that relative displacement can occur between the flexible display 01, and the first housing 10 and the second housing 20.

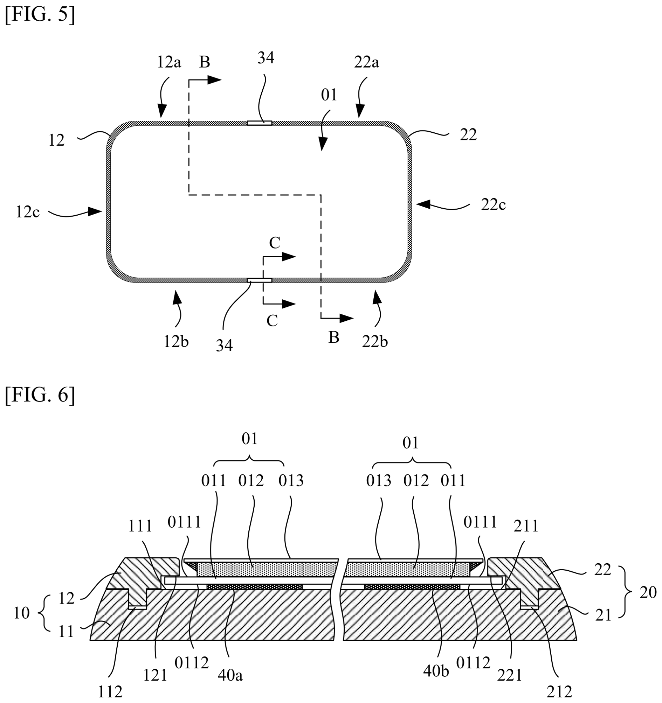

Specifically, as shown in FIG. 5 and FIG. 6, in an example provided in this application, the flexible display 01 includes a backplane 011 and a display panel 012. The backplane 011 has a first board surface 0111 and a second board surface 0112 that face away from each other. The back of the display panel 012 is fixedly attached to the first board surface 0111 of the backplane 011. The second board surface 0112 of the backplane 011 is disposed on the first board surface 0111 via a first flexible adhesive layer 40a.

The first housing 10 includes a first body 11 and a first side frame 12 that are fastened. The first body 11 has a first mounting surface 111, and the second board surface 0112 of the backplane 011 is disposed on the first mounting surface 111. The first side frame 12 has a first limiting surface 121, and the first limiting surface 121 is disposed facing the first mounting surface 111. The first limiting surface 121 is configured to press against the first board surface 0111, and a part of an edge (for example, a left edge in the figure) of the backplane 011 is limited between the first limiting surface 121 and the first mounting surface 111, to prevent an undesirable case of the flexible display 01 being detached from the first housing 10.

The first flexible adhesive layer 40a has specific adhesiveness and flexibility. The first flexible adhesive layer 40a can limit the backplane 011 onto the first mounting surface 111 of the first housing 10 via adhesiveness of the first flexible adhesive layer 40a, to prevent an undesirable case of warping or bulge between the backplane 011 and the first mounting surface 111. In addition, when a force in a direction parallel to the first mounting surface 111 (or the second board surface 0112) is exerted between the backplane 011 and the first housing 10, the relatively good flexibility of the first flexible adhesive layer 40a can allow for relative displacement between the backplane 011 and the first housing 10. This can effectively prevent the first housing 10 from significantly pulling or pressing the flexible display 01.

It should be noted that, in other examples, the first flexible adhesive layer 40a may alternatively be omitted. The backplane 011 may lap the first body 11, so that the second board surface 0112 is in contact with the first mounting surface 111. The first side frame 12 can limit the backplane 011 via the first limiting surface 121, to prevent the flexible display 01 from being detached from the first housing 10.

In addition, the second housing 20 includes a second body 21 and a second side frame 22 that are fastened. The second body 21 has a second mounting surface 211, and the second board surface 0112 of the backplane 011 is disposed on the second mounting surface 211 via a second flexible adhesive layer 40b. The second side frame 22 has a second limiting surface 221, and the second limiting surface 221 is disposed facing the second mounting surface 211. The second limiting surface 221 is configured to press against the first board surface 0111, and a part of an edge (for example, a right edge in the figure) of the backplane 011 is limited between the second limiting surface 221 and the second mounting surface 211, to prevent an undesirable case of the flexible display 01 being detached from the second housing 20.

The second flexible adhesive layer 40b has specific adhesiveness and flexibility. The second flexible adhesive layer 40b can limit the backplane 011 onto the second mounting surface 211 of the second housing 20 via adhesiveness of the second flexible adhesive layer 40b, to prevent an undesirable case of warping or bulge between the backplane 011 and the second mounting surface 211. For a disposition manner and a working principle of the second flexible adhesive layer 40b, refer to the first flexible adhesive layer 40a. Details are not described herein again.

It should be noted that, in other examples, the second flexible adhesive layer 40b may alternatively be omitted. The backplane 011 may lap the second body 21, so that the second board surface 0112 is in contact with the second mounting surface 211. The second side frame 22 can limit the backplane 011 via the second limiting surface 221, to prevent the flexible display 01 from being detached from the second housing 20.

In the example provided in this application, the first side frame 12 of the first housing 10 effectively limits the backplane 011, so that the flexible display 01 can be prevented from being detached from the first housing 10. Therefore, a height dimension of the first side frame 12 protruding from the display surface of the display panel 012 can be effectively reduced. Correspondingly, the second side frame 22 of the second housing 20 effectively limits the backplane 011, so that the flexible display 01 can be prevented from being detached from the second housing 20. Therefore, a height dimension of the second side frame 22 protruding from the display surface of the display panel 012 can be effectively reduced.

Alternatively, as shown in FIG. 3 and FIG. 6, the following may be understood. In FIG. 3, the first side frame 12 is pressed on the display surface of the display panel 012, and therefore inevitably protrudes from the display surface. In addition, to ensure structural strength of the first side frame 12, the structure protruding from the display surface definitely needs to have a sufficient thickness. In FIG. 6, because the first side frame 12 is pressed on the first board surface 0111 of the backplane 011, a dimension of the first side frame 12 protruding from the display surface of the display panel 012 can be effectively reduced. Even, in some cases, the first side frame 12 may be flush with or lower than the display surface. Therefore, this facilitates the reduction of the thickness dimension of the foldable device, and avoids the problem of hand scratching caused by the first side frame 12 protruding excessively from the display surface. In addition, the first side frame 12 does not block the display panel 012, facilitating the increase in a screen-to-body ratio of the foldable device. A structure of the second housing 20 and a manner of fitting between the second housing 20 and the flexible display 01 are similar to those of the first housing 10. Details are not described herein again.

It should be noted that, in other examples, the second side frame 22 of the second housing 20 also directly presses against the display surface of the display panel 012 of the flexible display 01. Refer to FIG. 3 and FIG. 6. Specifically, the second limiting surface 221 of the second side frame 22 may not press against the first board surface 0111 of the backplane 011, but press against the display surface of the display panel 012. In other words, a structure of the second side frame 22 and a manner of fitting between the second side frame 22 and the flexible display 01 may be of a currently commonly used type. Certainly, in the example provided in this application, after the second limiting surface 221 of the second side frame 22 presses against the first board surface 0111 of the backplane 011, the second side frame 22 can be prevented from blocking the flexible display 01, and the screen-to-body ratio of the flexible display 01 can be further increased. During specific configuration, the first side frame 12 and the second side frame 22 may be of various shapes.

For example, as shown in FIG. 5, in an example provided in this application, the first side frame 12 is approximately a U-shaped frame, and is disposed along three sides of the first body (not shown in the figure). The first side frame 12 has three sides: a first side 12a and a second side 12b that are disposed opposite to each other, and a side 12c located between the first side 12a and the second side 12b. During specific configuration, the first limiting surface 121 may be on any one of the first side 12a, the second side 12b, or the side 12c. In the example provided in this application, the first limiting surface 121 is on the first side 12a and the second side 12b. This allows for a relatively good limiting effect for the flexible display 01, and facilitates the increase in the screen-to-body ratio of the flexible display 01. Certainly, in other examples, the first limiting surface 121 may be on the first side 12a, the second side 12b, and the side 12c. During specific configuration, a position of the first limiting surface 121 may be properly selected according to actual requirements. Details are not described herein.

As shown in FIG. 6, a section of the first side frame 12 is approximately L-shaped. The first body 11 has a first mounting groove 112. One end of the first side frame 12 is fastened in the first mounting groove 112, and the other end is suspended on the first board surface 0111 of the backplane 011 and presses against the first board surface 0111.

As shown in FIG. 5, the second side frame 22 is approximately a U-shaped frame, and is disposed along three sides of the second body (not shown in the figure). The second side frame 22 has three sides: a third side 22a and a fourth side 22b that are disposed opposite to each other, and a side 22c located between the third side 22a and the fourth side 22b. During specific configuration, the second limiting surface 221 may be on any one of the third side 22a, the fourth side 22b, or the side 22c. In the example provided in this application, the second limiting surface 221 is on the third side 22a and the fourth side 22b. This allows for a relatively good limiting effect for the flexible display 01, and facilitates the increase in the screen-to-body ratio of the flexible display 01. Certainly, in other examples, the second limiting surface 221 may be on the third side 22a, the fourth side 22b, and the side 22c. During specific configuration, a position of the second limiting surface 221 may be properly selected according to actual requirements. Details are not described herein.

As shown in FIG. 6, a section of the second side frame 22 is approximately L-shaped. The second body 21 has a second mounting groove 212. One end of the second side frame 22 is fastened in the second mounting groove 212, and the other end is suspended on the first board surface 0111 of the backplane 011 and presses against the first board surface 0111.

In addition, as shown in FIG. 6, in an example provided in this application, the foldable device further includes a protective film layer 013. The protective film layer 013 is disposed on the display surface of the display panel 012, providing good protection for the display panel 012. A surface of the first side frame 12 that faces away from the first mounting surface 111 may protrude from a surface of the protective film layer 013 or be flush with the surface of the protective film layer 013. Alternatively, in some examples, the surface of the first side frame 12 that faces away from the first mounting surface 111 may be lower than the protective film layer 013. In actual application, a height difference between the surfaces of the first side frame 12 and the protective film layer 013 may be properly set according to actual requirements. Details are not described herein. Correspondingly, a surface of the second side frame 22 that faces away from the second mounting surface 211 may protrude from the surface of the protective film layer 013 or be flush with the surface of the protective film layer 013. Alternatively, in some examples, the surface of the second side frame 22 that faces away from the second mounting surface 211 may be lower than the protective film layer 013. In actual application, a height difference between the surfaces of the second side frame 22 and the protective film layer 013 may be properly set according to actual requirements. Details are not described herein.

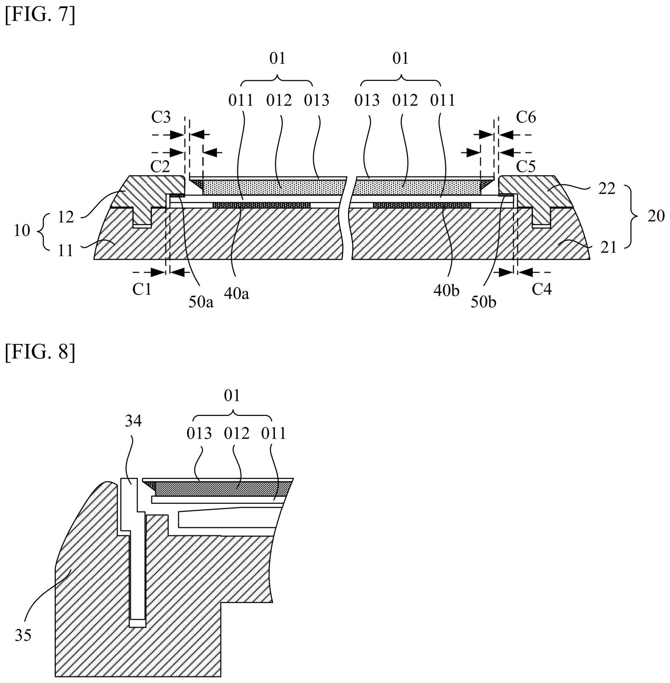

As shown in FIG. 7, there is a first gap C1 between a side of the backplane 011 and the first side frame 12, and there is a second gap C2 between the display panel 012 and the first side frame 12. The second gap C2 may be greater than the first gap C1. When the flexible display 01 is in contact with the first side frame 12, the backplane 011 first presses against the first side frame 12. This can prevent the display panel 012 from further approaching the first side frame 12, thereby preventing the display panel 012 from being in contact with the first side frame 12, and effectively ensuring safety of the display panel 012.

In addition, as shown in FIG. 7, there is a third gap C3 between a side of the protective film layer 013 and the first side frame 12. The first gap C1 may be less than the third gap C3. In actual application, structural strength of the backplane 011 is usually higher than structural strength of the protective film layer 013. In the process of the foldable device being folded or unfolded, the flexible display 01 may be in contact with the first side frame 12. In the example provided in this application, the first gap C1 between the backplane 011 and the first side frame 12 is less than the third gap C3 between the protective film layer 013 and the first side frame 12. When the flexible display 01 is in contact with the first side frame 12, the backplane 011 first presses against the first side frame 12. This can effectively prevent interference between the protective film layer 013 and the first side frame 12 from exerting a pressing force on the protective film layer 013, thereby ensuring safety of the protective film layer 013.

In summary, during specific configuration, the second gap C2 may be greater than the first gap C1 or the third gap C3, and a dimension relationship between the first gap C1 and the third gap C3 may be flexibly set.

Certainly, in some examples, the first gap C1 and the third gap C3 may alternatively be set to be relatively large, to avoid interference between the backplane 011 or the protective film layer 013 and the first side frame 12. In actual application, specific dimensions of the first gap C1 and the third gap C3 may be properly set. Details are not described herein.

In the example provided in this application, a relatively small dimension of the third gap C3 can effectively reduce the gap between the display panel 012 and the first side frame 12, improve structural consistency between the flexible display 01 and the first side frame 12, and effectively prevent a foreign matter from entering the space between the flexible display 01 and the first side frame 12 through the third gap C3.

In other examples, the first gap C1 may alternatively be the same as the third gap C3. Details are not described herein.

Correspondingly, there is a fourth gap C4 between a side of the backplane 011 and the second side frame 22, and there is a fifth gap C5 between the display panel 012 and the second side frame 22. For a manner of disposing the fourth gap C4, refer to the first gap C1 described above. For a manner of disposing the sixth gap C6, refer to the third gap C3 described above. For a manner of disposing the fifth gap C5, refer to the second gap C2 described above. Details are not described herein again.

In addition, during specific implementation, there may also be various manners of fitting between the first limiting surface 121 and the first board surface 0111.

For example, as shown in FIG. 6, in an example provided in this application, the first limiting surface 121 laps the first board surface 0111. That is, the first limiting surface 121 abuts against the first board surface 0111, and the first limiting surface 121 can directly press against the first board surface 0111. Certainly, in other examples, a specific gap may be maintained between the first limiting surface 121 and the first board surface 0111. When the first limiting surface 121 is in contact with the first board surface 0111, the first limiting surface 121 can press against the first board surface 0111.

Alternatively, as shown in FIG. 7, in an example provided in this application, there is a first sealing strip 50a between the first limiting surface 121 and the first board surface 0111, and the first limiting surface 121 can press against the first board surface 0111 via the first sealing strip 50a. One side of the first sealing strip 50a is tightly fitted to the first limiting surface 121, and the other side is tightly fitted to the first board surface 0111, so that sealing performance between the first side frame 12 and the backplane 011 can be effectively improved.

The first sealing strip 50a may be bonded and fastened to the first board surface 0111 or the first limiting surface 121 by glue, so that the first sealing strip 50a can be effectively fastened between the first limiting surface 121 and the first board surface 0111, without affecting relative sliding between the first limiting surface 121 and the first board surface 0111.

In a specific application, the first sealing strip 50a may be foam, rubber, or the like. A specific material of the first sealing strip 50a is not limited in this application.

In addition, during specific implementation, for a manner of fitting between the second limiting surface 221 and the first board surface 0111, refer to the foregoing manner of fitting between the first limiting surface 121 and the first board surface 0111. For a manner of disposing a second sealing strip 50b, refer to the first sealing strip 50a. Details are not described herein again.

In addition, as shown in FIG. 6 and FIG. 8, in an example provided in this application, the hinge 30 includes a hinge side frame 34, and the hinge side frame 34 is located between the first side frame 12 and the second side frame 22. There are two hinge side frames 34, which are respectively located on two sides of the flexible display 01. In addition, there is a gap between the hinge side frame 34 and the side of the flexible display 01. The hinge side frame 34 can effectively connect the first side frame 12 and the second side frame 22. In addition, the hinge side frame 34 can provide good protection for the side of the flexible display 01, to prevent the flexible display 01 from being bumped by a foreign matter.

Specifically, as shown in FIG. 8, in an example provided in this application, the hinge 30 further includes a bracket 35. One end of the hinge side frame 34 is fastened onto the bracket 35, and the other end extends toward the surface of the flexible display 01 and blocks the side of the flexible display 01.

Refer to FIG. 3 and FIG. 8 together. The hinge side frame 34 is mainly used to connect the first side frame 12 and the second side frame 22. Therefore, a width dimension of the hinge side frame 34 is usually consistent with a width dimension of the first side frame 12 and of the second side frame 22. In the example provided in this application, because the width dimensions of both the first side frame 12 and the second side frame 22 can be effectively reduced, the width dimension of the hinge side frame 34 can also be effectively reduced. The hinge side frame 34 does not need to cover the flexible display 01, facilitating the increase in the screen-to-body ratio of the foldable device.

In addition, in the example provided in this application, because the hinge side frame 34 does not cover the flexible display 01, that is, there is no need for a part blocking the flexible display 01, the hinge side frame 34 may be made of a soft material like rubber or plastic, thereby improving flexibility in material selection. Alternatively, it may be understood that, in the conventional technology, the hinge side frame needs to cover the flexible display 01, and the hinge side frame needs to have specific stiffness to protect the flexible display 01. Therefore, a material with good stiffness needs to be selected for the hinge side frame. During specific configuration of this application, the hinge side frame 34 does not need to cover the flexible display 01 as in the conventional technology, but can be designed to be lower than the flexible display 01 or flush with the flexible display 01. Therefore, a soft material like rubber or plastic may be used, thereby improving flexibility in material selection.

As shown in FIG. 7, in actual application, in the first housing 10, the first body 11 and the first side frame 12 may be two independent structural parts. In actual production, the first body 11 and the first side frame 12 may be separately manufactured and formed, and then the first body 11 and the first side frame 12 are fastened. Alternatively, in some embodiments, the first body 11 and the first side frame 12 may be an integral structure. Correspondingly, in the second housing 20, the second body 21 and the second side frame 22 may be two independent structural parts. In actual production, the second body 21 and the second side frame 22 may be separately manufactured and formed, and then the second body 21 and the second side frame 22 are fastened. Alternatively, in some embodiments, the second body 21 and the second side frame 22 may be an integral structure. This is not limited in this application.

The foregoing descriptions are merely specific implementations of this application, but are not intended to limit the scope of protection of this application. Any variation or replacement readily figured out by a person skilled in the art within the technical scope disclosed in this application shall fall within the scope of protection of this application. Therefore, the scope of protection of this application shall be subject to the scope of protection of the claims.

## Claims

1. A foldable device, comprising:
a flexible display, comprising a backplane and a display panel, wherein
the backplane has a first board surface and a second board surface that face away from each other, and the back of the display panel is disposed on the first board surface;
the first housing, comprising a first body and a first side frame that are fastened, wherein the first body has a first mounting surface, and the second board surface of the backplane is disposed on the first mounting surface; and
the first side frame has a first limiting surface, the first limiting surface is disposed facing the first mounting surface, the first limiting surface is configured to press against the first board surface, and a part of an edge of the backplane is limited between the first limiting surface and the first mounting surface;
the second housing, comprising a second body, wherein the second body has a second mounting surface, and the second board surface of the backplane is disposed on the second mounting surface; and
a hinge, located between the first body and the second body and connected to the first body and the second body.

2. The foldable device according to claim 1, wherein the first side frame has a first side and a second side, and the first limiting surface is on the first side and the second side.

3. The foldable device according to claim 2, wherein the first side and the second side are disposed opposite to each other.

4. The foldable device according to any one of claims 1 to 3, wherein the second body further comprises a second side frame, and the second side frame is fastened to the second body;
the second body has the second mounting surface, and the second board surface of the backplane is disposed on the second mounting surface; and
the second side frame has a second limiting surface, the second limiting surface is disposed facing the second mounting surface, the second limiting surface is configured to press against the first board surface, and a part of an edge of the backplane is limited between the second limiting surface and the second mounting surface.

5. The foldable device according to claim 4, wherein the second side frame has a third side and a fourth side, and the second limiting surface is on the third side and the fourth side.

6. The foldable device according to claim 5, wherein the third side and the fourth side are disposed opposite to each other.

7. The foldable device according to any one of claims 1 to 6, wherein the first limiting surface laps the first board surface.

8. The foldable device according to any one of claims 1 to 6, wherein the foldable device further comprises a first sealing strip; and
the first sealing strip is located between the first limiting surface and the first board surface, and the first sealing strip is fastened to the first side frame or the backplane.

9. The foldable device according to any one of claims 4 to 6, wherein the second limiting surface laps the first board surface.

10. The foldable device according to any one of claims 4 to 6, wherein the foldable device further comprises a second sealing strip; and
the second sealing strip is located between the second limiting surface and the first board surface, and the second sealing strip is fastened to the second side frame or the backplane.

11. The foldable device according to any one of claims 4 to 10, wherein the foldable device further comprises a protective film layer, the protective film layer is disposed on a display surface of the display panel, and at least a part of an edge of the protective film layer extends beyond an edge of the display panel.

12. The foldable device according to claim 11, wherein a surface of the first side frame is flush with a surface of the protective film layer in a direction away from the first mounting surface; and
a surface of the second side frame is flush with the surface of the protective film layer in a direction away from the second mounting surface.

13. The foldable device according to claim 11, wherein a first gap is provided between a side of the backplane and the first side frame, a second gap is provided between the display panel and the first side frame, a third gap is provided between a side of the protective film layer and the first side frame, and the second gap is greater than the first gap or the third gap; and
a fourth gap is provided between a side of the backplane and the second side frame, a fifth gap is provided between the display panel and the first side frame, a sixth gap is provided between a side of the protective film layer and the second side frame, and the fifth gap is greater than the third gap or the sixth gap.

14. The foldable device according to any one of claims 4 to 13, wherein the hinge comprises a hinge side frame, the hinge side frame is located between the first side frame and the second side frame, and a side of the hinge side frame adjacent to the flexible display is lower than or flush with the flexible display.

15. The foldable device according to claim 14, wherein the hinge side frame is made of plastic or rubber.
